# EUROPÄISCHE PATENTSCHRIFT

(11) **EP 2 008 352 B1**
(45) Veröffentlichungstag und Bekanntmachung des Hinweises auf die Patenterteilung: **09.06.2010**
(21) Anmeldenummer: 06722814.8
(22) Anmeldetag: 18.04.2006
(51) Int. Cl.: H02J 3/00

(54) **VERFAHREN ZUM ÜBERWACHEN DER ELEKTROENERGIEQUALITÄT IN EINEM ELEKTRISCHEN ENERGIEVERSORGUNGSNETZ, POWER-QUALITY-FELDGERÄT UND POWER-QUALITY-SYSTEM**
METHOD FOR MONITORING THE ELECTRICAL ENERGY QUALITY IN AN ELECTRICAL ENERGY SUPPLY SYSTEM, POWER QUALITY FIELD DEVICE AND POWER QUALITY SYSTEM
PROCÉDÉ DE CONTRÔLE DE LA QUALITÉ DE L'ÉNERGIE ÉLECTRIQUE DANS UN RÉSEAU D'ALIMENTATION EN ÉNERGIE ÉLECTRIQUE, APPAREIL DE TERRAIN DE CONTRÔLE DE LA QUALITÉ DE COURANT ET SYSTÈME DE CONTRÔLE DE LA QUALITÉ DE COURANT

(43) Veröffentlichungstag der Anmeldung: 31.12.2008
(73) Patentinhaber: SIEMENS AKTIENGESELLSCHAFT, 80333 München (DE)
(72) Erfinder: ANKLAM, Uwe, 91126 Kammerstein (DE)
(86) Internationale Anmeldenummer: PCT/DE2006/000696
(87) Internationale Veröffentlichungsnummer: WO 2007/118436

(56) Entgegenhaltungen:
- WO-A-2005/052617
- US-A1- 2005 187 725
- US-A1- 2006 066 456

## Beschreibung

Die Erfindung betrifft ein Verfahren zum Überwachen der Elektroenergiequalitat in einem elektrischen Energieversorgungsnetz, bei dem folgende Schritte durchgeführt werden:
- Erfassen eines ersten Messwertes einer ersten Power-Quality-Kenngröße mittels einer Messeinrichtung eines an einer Messstelle des elektrischen Energieversorgungsnetzes angeordneten Power-Quality-Feldgerätes zu einem ersten Messzeitpunkt und
- Vergleichen des ersten Messwertes mit zumindest einem vorgegebenen Schwellenwert.

Die Erfindung betrifft auch ein entsprechendes Power-Qualtiy-Feldgerät sowie ein Power-Quality-System.

Elektrische Energieversorgungsnetze stellen heutzutage hoch komplexe Netzwerke zur Verteilung elektrischer Energie dar, die oft eine große Anzahl von Energieeinspeisungen und -entnahmen aufweisen. Neben der Versorgungssicherheit, d.h. der Gewährleistung, dass zu jedem Zeitpunkt für jeden Energieabnehmer eine ausreichende Menge elektrischer Energie verfügbar ist, spielt auch die Qualität der gelieferten elektrischen Energie (im Folgenden als "Elektroenergiequalität" oder "Power-Quality" bezeichnet) eine entscheidende Rolle. Die Elektroenergiequalität im Energieversorgungsnetz lässt sich beispielsweise an so genannten Power-Quality-Kenngrößen wie z.B. Frequenz, Spannung und Spannungs- oder Stromoberwellen, Klirrfaktoren, Flicker, Spannungsunsymmetrien und Leistungen festmachen. Hoch sensible elektrische Geräte verlangen heutzutage eine elektrische Energieversorgung in Form einer möglichst reinen Sinuswelle mit einer einheitlichen Frequenz und Amplitude. In Normwerken wie der EN 50160 oder der IEC 61000 sind daher obere und untere Grenzwerte vorgeschrieben, innerhalb derer diese Power-Quality-Kenngrößen eines Energieversorgungsnetzes liegen müssen.

Um Aussagen über die Elektroenergiequalität treffen zu können, sind an verschiedenen Messstellen des elektrischen Energieversorgungsnetzes Power-Quality-Feldgeräte vorgesehen, die Messwerte der jeweiligen Power-Quality-Kenngrößen aufnehmen. In Power-Quality-Feldgeräten können die aufgenommenen Messwerte üblicherweise zur Archivierung abgespeichert werden. Zur Auswertung der Messwerte dahingehend, ob zu bestimmten Zeitpunkten Grenzwertüberschreitungen stattgefunden haben, werden die gespeicherten Messwerte in regelmäßigen Abständen an andere Datenverarbeitungseinrichtungen wie z.B. zentrale Auswerterechner übermittelt, mit denen eine Auswertung stattfindet. So können in dem zentralen Auswerterechner zeitabhängige Verläufe der Power-Quality-Kenngrößen erzeugt und die Einhaltung der Grenzwerte geprüft bzw. nachgewiesen werden.

Da die in den Power-Quality-Feldgeräten eingebauten Datenspeichermodule aus Kostengründen nicht beliebig groß gewählt werden können, muss die Übertragung der abgespeicherten Messwerte an den zentralen Auswerterechner verhältnismäßig häufig durchgeführt werden. Wird eine Übertragung der abgespeicherten Messwerte nicht rechtzeitig vorgenommen, so können wegen des vollständig gefüllten Datenspeichers entweder keine neuen Messwerte mehr abgespeichert werden oder es werden alte Messwerte mit jüngeren überschrieben (so genannter "Ringspeicherbetrieb"). Um hierbei die Zeitabstände zwischen zwei Übertragungsvorgängen zu vergrößern, müsste daher ein entsprechend größerer Datenspeicher in dem Power-Quality-Feldgerät vorgesehen werden.

Aus der internationalen Patentanmeldung WO 2005/052617 A1 ist eine Diagnoseeinheit für eine Stromversorgung bekannt, die aufgenommene Messwerte auf unzulässige Abweichungen von einem Vergleichswert überprüft und Messwerte im zeitlichen Umfeld einer unzulässigen Abweichung in einem Speicher ablegt.

Der Erfindung liegt die Aufgabe zugrunde, ein Verfahren zum Überwachen der Elektroenergiequalität eines elektrischen Energierversorgungsnetzes, ein Power-Quality-Gerät sowie ein Power-Quality-System anzugeben, wodurch eine Überwachung der Elektroenergiequalität mit vergleichsweise geringem Aufwand ermöglicht wird.

Hinsichtlich des Verfahrens wird diese Aufgabe durch ein Verfahren zum Überwachen der Elektroenergiequalität in einem elektrischen Energieversorgungsnetz gelöst, dass
- ein zweiter Messwert der ersten Power-Quality-Kenngröße mittels der Messeinrichtung des Power-Quality-Feldgerätes zu einem auf den ersten Messzeitpunkt unmittelbar folgenden zweiten Messzeitpunkt erfasst wird;
- auch der zweite Messwert mit dem zumindest einen vorgegebenen Schwellenwert verglichen wird und
- ein eine Verletzung des zumindest einen Schwellenwertes angebenden Ereignis-Signals genau dann erzeugt wird, wenn einer der beiden Messwerte oberhalb und einer der beiden Messwerte unterhalb des zumindest einen Schwellenwertes liegt.

Der wesentliche Vorteil des erfindungsgemäßen Verfahrens besteht darin, dass von dem Power-Quality-Feldgerät bereits eine erste Bewertung des Zustandes der Elektroenergiequalität des elektrischen Energieversorgungsnetzes getroffen wird, so dass nicht mehr alle erfassten Messwerte zur späteren Auswertung in einem Datenspeicher des Power-Quality-Feldgerätes abgespeichert werben müssen, sondern lediglich bei Verletzung zumindest eines der dem Power-Quality-Feldgerät bekannten Schwellenwerte ein Ereignis-Signal erzeugt wird. Hierdurch können notwendige Speicherkapazität und damit verbundene Kosten hinsichtlich des Power-Quality-Feldgerätes deutlich verringert werden.

Eine vorteilhafte Weiterbildung des erfindungsgemäßen Verfahrens sieht vor, dass das Ereignis-Signal zur Ansteuerung einer optischen Signaleinrichtung des Power-Quality-Feldgerätes verwendet wird. Auf diese Weise kann direkt am Power-Quality-Feldgerät eine Schwellenwertverletzung angezeigt werden. Bei der Anzeigeeinrichtung kann es sich dabei z.B. um eine Leuchtdiode, die lediglich das Vorhandensein einer Schwellenwertverletzung anzeigt, oder um einen Bildschirm (z.B. ein LCD), der zusätzliche Informationen hinsichtlich des verletzten Schwellenwertes angibt, handeln.

Eine weitere vorteilhafte Ausführungsform des erfindungsgemäßen Verfahrens sieht vor, dass das Ereignis-Signal eine Steuereinrichtung des Power-Quality-Feldgerätes zum Erzeugen eines Datentelegramms veranlasst, wobei das Datentelegramm zumindest einen den verletzten Schwellenwert angebenden Datensatz enthält. Hierdurch wird sozusagen eine Alarmmeldung in Form des Datentelegramms generiert, die dem Betriebspersonal des elektrischen Energieversorgungsnetzes Informationen über den verletzten Schwellenwert angibt. Zusätzlich können weitere Informationen, wie z.B. eine Identifikation (z.B. eine Fabrikationsnummer) des Power-Quality-Feldgerätes in dem Datentelegramm enthalten sein, damit das Betriebspersonal, die Schwellenwertverletzung eindeutig einem bestimmten Power-Quality-Feldgerät und damit einer bestimmten Messstelle in dem elektrischen Energieversorgungsnetz zuordnen kann.

In diesem Zusammenhang wird es ferner als vorteilhaft angesehen, wenn das Datentelegramm zusätzlich einen den ersten und/oder den zweiten Messzeitpunkt angebenden Datensatz enthält. Hierdurch kann die Schwellenwertverletzung eindeutig einem Zeitpunkt zugeordnet werden.

Zudem ist es in diesem Zusammenhang von Vorteil, wenn das Datentelegramm zusätzlich eine Information darüber enthält, ob der verletzte Schwellenwert durch eine Überschreitung oder eine Unterschreitung verletzt worden ist. Hierdurch kann sozusagen eine Richtung der Schwellenwertverletzung angegeben werden.

Ferner kann in diesem Zusammenhang vorgesehen sein, dass das Datentelegramm zusätzlich den ersten und/oder den zweiten Messwert enthält. Hierdurch kann eine noch ausführlichere Auswertung der Schwellenwertverletzung vorgenommen werden, da anhand der Messwerte auch die Höhe der Schwellenwertüber- bzw. -unterschreitung festgestellt werden kann.

In diesem Zusammenhang kann zudem vorteilhaft vorgesehen sein, dass das Datentelegramm in einem Fest-Datenspeicher des Power-Quality-Feldgerätes abgespeichert und/oder an eine dem Power-Quality-Feldgerät übergeordnete Datenverarbeitungseinrichtung übertragen wird. Hierdurch kann das Betriebspersonal entweder bei Übertragung des Datentelegramms direkt mittels der übergeordneten Datenverarbeitungseinrichtung oder bei Abspeichern des Datentelegramms im Power-Quality-Feldgerät durch Auslesen des Fest-Datenspeichers auf das Datentelegramm zugreifen. Auch beim Abspeichern des Datentelegramms im Power-Quality-Feldgerät wird im Vergleich zum Abspeichern aller Messwerte eine deutliche Verringerung des benötigten Speicherplatzbedarfs erreicht.

Eine weitere vorteilhafte Ausführungsform des erfindungsgemäßen Verfahrens sieht vor, dass das Ereignis-Signal eine Steuereinrichtung des Power-Quality-Feldgerätes zum Abspeichern des ersten Messwertes und/oder des zweiten Messwertes in einen Fest-Datenspeicher des Power-Quality Feldgerätes veranlasst. Es werden hierbei also nur diejenigen beiden Messwerte abgespeichert, zwischen denen eine Schwellenwertverletzung stattfindet. Hierdurch werden deutlich weniger Messwerte in dem Fest-Datenspeicher abgelegt als bei einer kontinuierlichen Datenspeicherung, so dass dessen Kapazität für einen erheblich längeren Messzeitraum ausreicht.

Gemäß einer vorteilhaften Weiterbildung des erfindungsgemäßen Verfahrens ist vorgesehen, dass zusätzlich zu den Messwerten auch der erste und/oder der zweite Messzeitpunkt in dem Fest-Datenspeicher abgespeichert werden. Hierdurch kann bei der Auswertung der abgespeicherten Messwerte eindeutig festgestellt werden, zu welchem Zeitpunkt eine Schwellenwertverletzung stattgefunden hat.

Eine weitere vorteilhafte Ausführungsform des erfindungsgemäßen Verfahrens sieht vor, dass das Power-Quality-Feldgerät (50) einen Zeittakt eines geräteinternen Zeitgebers erfasst und anhand dieses Zeittaktes den Messzeitpunkt des jeweiligen Messwertes bestimmt. Hierdurch kann auf einfache Art und Weise jedem Messwert ein so genannter Zeitstempel zugeordnet werden.

Als besonders vorteilhaft wird es jedoch angesehen, wenn das Power-Quality-Feldgerät einen externen Zeittakt erfasst und anhand dieses externen Zeittaktes den Messzeitpunkt des jeweiligen Messwertes bestimmt. Durch das Vorsehen eines externen Zeittaktes, also eines Zeittaktes, der außerhalb des Feldgerätes erzeugt wird (z.B. ein GPS-Zeitsignal), können die Messwerte mehrerer Power-Quality-Feldgeräte noch besser miteinander verglichen werden, da jedes Power-Quality-Feldgerät zeitlich mit den anderen Power-Quality-Feldgeräten synchronisiert ist. Somit bekommt jeder Messwert einen ausschließlich durch den äußeren Zeittakt bestimmten Messzeitpunkt zugeordnet, der auch in den übrigen Power-Quality-Feldgeräten absolute Gültigkeit hat.

Eine weitere vorteilhafte Ausführungsform des erfindungsgemäßen Verfahrens sieht außerdem vor, dass neben Messwerten der ersten Power-Quality-Kenngröße auch Messwerte mindestens einer weiteren Power-Quality-Kenngröße erfasst werden und ein weiteres Ereignis-Signal erzeugt wird, wenn zwei zeitlich unmittelbar aufeinander folgende Messwerte der mindestens einen weiteren Power-Quality-Kenngröße auf unterschiedlichen Seiten zumindest eines weiteren Schwellenwertes liegen. Auf diese Weise kann eine komplette Analyse der relevanten Power-Quality-Kenngrößen mit einem Power-Quality-Feldgerät durchgeführt werden.

Schließlich wird es noch als vorteilhaft bezüglich des erfindungsgemäßen Verfahrens angesehen, wenn das Ereignis-Signal die Steuereinrichtung auch zur Ausführung von weiteren Power-Quality-Funktionen des Power-Quality-Feldgerätes veranlasst. Hierbei kann durch das Ereignis-Signal beispielsweise das Power-Quality-Feldgerät zur Aufnahme zusätzlicher Messwerte über einen definierten Zeitraum, also zur Erzeugung eines so genannten Störschriebes, veranlasst werden, anhand dessen die Messwertverläufe der Power-Quality-Kenngrößen vor und nach der Schwellenwertverletzung genau dargestellt werden können. Solche Störschriebe können entweder im Fest-Datenspeicher des Power-Quality-Feldgerätes abgespeichert werden oder an eine übergeordnete Datenverarbeitungseinrichtung übertragen werden. Neben der Erstellung von Störschrieben kann durch das Ereignis-Signal beispielsweise auch eine Erhöhung der Sampling-Rate, mit der die Messwerte aufgenommen werden, getriggert werden.

Hinsichtlich des Power-Quality-Feldgerätes wird die oben genannte Aufgabe erfindungsgemäß durch ein Power-Quality-Feldgerät zum Überwachen der Elektroenergiequalität in einem elektrischen Energieversorgungsnetz gelöst mit einer Messeinrichtung zum Erfassen von Messwerten einer Power-Quality-Kenngröße an einer Messstelle des elektrischen Energieversorgungsnetzes und einer Steuereinrichtung, die derart eingerichtet ist, dass sie die erfassten Messwerte mit zumindest einem vorgegebenen Schwellenwert vergleicht, bei dem die Steuereinrichtung ein Ereignis-Signal erzeugt, wenn von zwei unmittelbar aufeinander folgenden Messwerten einer oberhalb und einer unterhalb des zumindest einen Schwellenwertes liegt. Hierdurch wird bereits eine Bewertung des Zustandes der Elektroenergiequalität des elektrischen Energieversorgungsnetzes getroffen. Zudem kann die in dem Fest-Datenspeicher abzuspeichernde Datenmenge im Vergleich zu einer kontinuierlichen Datenspeicherung deutlich reduziert werden, da lediglich ein Ereignis-Signal erzeugt wird.

Vorteilhafterweise kann das Power-Quality-Feldgerät mit einer Anzeigeeinrichtung (Leuchtdiode, Bildschirm) versehen sein, die durch das Ereignis-Signal aktivierbar ist.

Eine vorteilhafte Weiterbildung des erfindungsgemäßen Power-Quality-Feldgerätes sieht vor, dass es eine Kommunikationseinrichtung aufweist, die bei Vorliegen des Ereignis-Signals ein den verletzten Schwellenwert angebendes Datentelegramm an eine dem Power-Quality-Feldgerät übergeordnete Datenverarbeitungseinrichtung sendet. Durch das sofortige Versenden des Datentelegramms kann Speicherplatz in dem Power-Quality-Feldgerät eingespart werden.

Zudem kann vorteilhafterweise vorgesehen sein, dass das Power-Quality-Feldgerät einen Fest-Datenspeicher aufweist, in dem bei Vorliegen des Ereignis-Signals mittels der Steuereinrichtung zumindest ein den verletzten Schwellenwert angebender Datensatz abgespeichert wird. Auch bei dieser Weiterbildung wird im Vergleich zu einer kontinuierlichen Datenspeicherung Speicherkapazität des Power-Quality-Feldgerätes eingespart.

Vorteilhafterweise kann vorgesehen sein, dass die Steuereinrichtung auch zur Durchführung von Funktionen zum Schutz von Komponenten eines elektrischen Energieversorgungsnetzes eingerichtet ist. In diesem Fall handelt es sich um ein kombiniertes Power-Quality-Feldgerät und Schutzgerät. Hierdurch kann insgesamt eine geringere Anzahl von Feldgeräten für ein elektrisches Energieversorgungsnetz vorgesehen werden als bei Verwendung getrennter Power-Quality-Feldgeräte und Schutzgeräte. Außerdem können in diesem Fall sowohl die Power-Quality-Funktionen als auch die Schutzfunktionen des kombinierten Feldgerätes auf dieselben Messeingänge zugreifen, so dass eine geringe Anzahl von Messwandlern benötigt wird.

Eine weitere vorteilhafte Ausführungsform des erfindungsgemäßen Feldgerätes sieht vor, dass es einen geräteinternen Zeitgeber aufweist, der zum Erzeugen eines Zeittaktes eingerichtet ist, und die Steuereinrichtung zum Bestimmen des jeweiligen Messzeitpunktes der einzelnen erfassten Messwerte anhand dieses Zeittaktes eingerichtet ist. Hierdurch kann in einfacher Weise jedem Messwert ein Zeitstempel zugeordnet werden.

Gemäß einer besonders vorteilhaften Ausführungsform des erfindungsgemäßen Power-Quality-Feldgerätes ist jedoch vorgesehen, dass es eine Empfangseinrichtung aufweist, die zum Empfangen eines externen Zeittaktes eingerichtet ist, und die Steuereinrichtung zum Bestimmen des jeweiligen Messzeitpunktes der einzelnen erfassten Messwerte anhand des empfangenen externen Zeittaktes eingerichtet ist. Auf diese Weise kann das Power-Quality-Feldgerät den Messwerten Messzeitpunkte zuordnen, die lediglich von dem externen Zeittakt abhängig sind und damit auch in anderen Geräten, die denselben Zeittakt empfangen, Gültigkeit haben. Vorteilhafterweise kann in diesem Zusammenhang vorgesehen sein, dass die Empfangseinrichtung ein GPS-Empfänger ist.

Mehrere solcher Power-Quality-Feldgeräte können mit einerzentralen Datenverarbeitungseinrichtung, mit der sie über ein Datenkommunikationsnetzwerk in Verbindung stehen, ein Power-Quality-System bilden.

Im Folgenden ist die Erfindung anhand von Ausführungsbeispielen dargestellt. Hierzu zeigen im Einzelnen
- Figur 1: ein erstes Ausführungsbeispiel eines elektrischen Power-Quality-Feldgerätes in schematischer Blockschaltbilddarstellung,
- Figur 2: ein Verfahrensfließbild zur Erläuterung eines Verfahrens zum Überwachen der Elektroenergiequalität eines elektrischen Energieversorgungsnetzes,
- Figur 3: ein erstes Diagramm mit einem beispielhaften Verlauf von Messwerten,
- Figur 4: ein zweites Diagramm mit einem zweiten beispielhaften Verlauf von Messwerten,
- Figur 5: ein zweites Ausführungsbeispiel eines elektrischen Power-Quality-Feldgerätes und
- Figur 6: ein mehrere elektrische Power-Quality-Feldgeräte umfassendes Power-Quality-System.

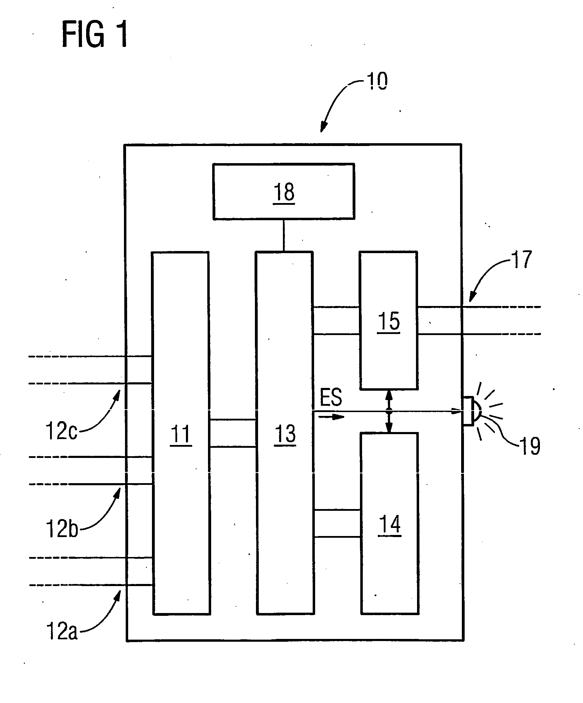

In Figur 1 ist höchstschematisch ein elektrisches Power-Quality-Feldgerät 10 dargestellt. Das Power-Quality-Feldgerät 10 weist eine Messeinrichtung 11 mit Messeingängen 12a, 12b und 12c zum Aufnehmen von Messwerten auf. Ausgangsseitig ist die Messeinrichtung 11 des elektrischen Power-Quality-Feldgerätes 10 mit einer Steuereinrichtung 13 verbunden, die selbst ausgangsseitig mit einem Fest-Datenspeicher 14 in Verbindung steht. Unter einem Fest-Datenspeicher soll in diesem Zusammenhang ein Datenspeicher verstanden werden, der im Gegensatz beispielsweise zu einem flüchtigen Datenspeicher zum dauerhaften Speichern von Daten geeignet ist. Dabei kann es sich um einen so genannten Permanent-Datenspeicher handeln, der ohne Energiezufuhr von außen eine dauerhafte Datenspeicherung gewährleistet, wie z.B. ein Flash-Speicher oder eine Festplatte. Unter einem Fest-Datenspeicher soll im Zusammenhang mit der Erfindung aber auch ein flüchtiger Datenspeicher verstanden werden, der über eine äußere Energiequelle mit elektrischer Energie versorgt wird, so dass eine dauerhafte Datenspeicherung zumindest bis zu einem Abruf der in dem e-nergiegepufferten flüchtigen Datenspeicher erfolgt ist.

Die Steuereinrichtung 13 des Power-Quality-Feldgerätes 10 steht zudem auch mit einer Kommunikationseinrichtung 15 in Verbindung, die über einen Kommunikationsausgang 17 eine Datenverbindung zwischen dem Power-Quality-Feldgerät 10 und weiteren Geräten herstellt. Obwohl der Kommunikationsausgang in Figur 1 als kabelgebundene Datenverbindungsstrecke angedeutet ist, kann stattdessen auch eine kabellose Datenverbindung beispielsweise über Funk oder Infrarot vorgesehen sein, über die Daten an eine entsprechend ausgebildete Empfangseinrichtung gesendet werden können. Außerdem kann es sich bei der Kommunikationseinrichtung 15 auch um eine Einrichtung handeln, mittels der ein externer Datenspeicher mit dem Power-Quality-Feldgerät 10 in Verbindung gebracht werden kann, wie beispielsweise eine USB-Schnittstelle oder ein Laufwerk für optische oder magnetischen Datenspeichermedien.

Die Steuereinrichtung 13 steht ferner in Verbindung mit einem Zeitgeber 18, beispielsweise einer quarzgesteuerten internen Geräteuhr, die der Steuereinrichtung einen Zeitimpuls bereitstellt, mit dessen Hilfe der jeweilige Messzeitpunkt der einzelnen von der Messeinrichtung 11 aufgenommenen Messwerte bestimmt werden kann.

Das Power-Quality-Feldgerät 10 stellt ein Feldgerät zur Überwachung der Elektroenergiequalität von Komponenten eines elektrischen Energieversorgungsnetzes, wie beispielsweise einem Abschnitt einer Elektroenergieübertragungsleitung, einer Sammelschiene oder einem Transformator dar.

Üblicherweise nehmen herkömmliche Power-Quality-Feldgeräte Messwerte von Power-Quality-Kenngrößen an den einzelnen Komponenten auf und speichern diese kontinuierlich in einem Fest-Datenspeicher des herkömmlichen elektrischen Power-Quality-Feldgerätes. Da der Fest-Datenspeicher zum Speichern einer begrenzten Menge von Messwerten ausgelegt ist, müssen die in ihm abgespeicherten Messwerte ausgelesen werden, bevor die Speicherkapazität des Fest-Datenspeichers überschritten wird. Ein solcher Auslesevorgang kann entweder direkt am Power-Quality-Feldgerät durch Übertragung der Messwerte auf einen mit dem elektrischen Power-Quality-Feldgerät temporär in Verbindung gebrachten transportablen Datenspeichers wie beispielsweise eine Diskette oder einen USB-Stick erfolgen. Alternativ können die Messwerte auch von dem elektrischen Power-Quality-Feldgerät über eine Datenübertragungsstrecke, die sowohl kabelgebunden als auch kabellos ausgeführt sein kann, an eine andere Datenverarbeitungseinrichtung, beispielsweise einen zentralen Auswerterechner, übertragen werden.

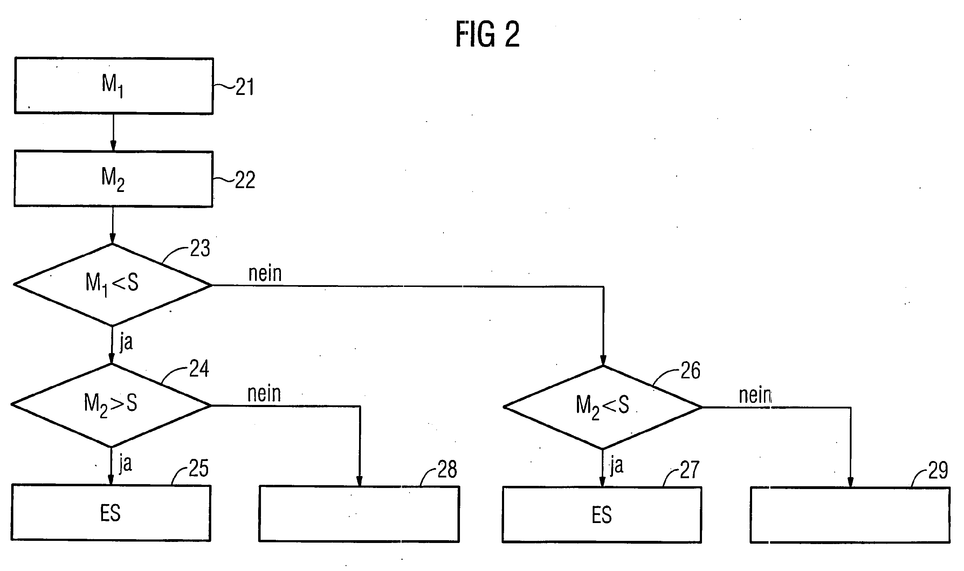

Da zur Auswertung des Verhaltens von Power-Quality-Kenngrößen insbesondere diejenigen Messwerte von Interesse sind, mit denen eine Verletzung vorgegebener Schwellenwerte stattgefunden hat, wird bei dem in Figur 1 dargestellten Power-Quality-Feldgerät 10 das im Folgenden unter Hinzunahme der Figur 2 beschriebene Verfahren zum Überwachen der Elektroenergiequalität eines elektrischen Energieversorgungsnetzes durchgeführt.

In einem in Figur 2 dargestellten ersten Schritt 21 wird ein erster Messwert M₁ einer ersten Power-Quality-Kenngröße an einem Messeingang, beispielsweise dem Messeingang 12a, des elektrischen Power-Quality-Feldgerätes 10 mittels der Messeinrichtung 11 erfasst. Bei der ersten Power-Quality-Kenngröße kann es sich beispielsweise um eine an einem Abschnitt eines elektrischen Energieversorgungsnetzes erfasste Spannung handeln. In einem darauf folgenden zweiten Schritt 22 wird wiederum mittels des Messeingangs 12a der Messeinrichtung 11 ein zweiter Messwert M₂ der ersten Power-Quality-Kenngröße erfasst, der zeitlich unmittelbar auf den ersten Messwert M₁ folgt. Diese beiden erfassten Messwerte M₁ und M₂ werden an die Steuereinrichtung 13 des elektrischen Power-Quality-Feldgerätes 10 übergeben.

Die Steuereinrichtung 13 prüft gemäß einem folgenden Schritt 23, ob der in Schritt 21 aufgenommene erste Messwert M₁ unterhalb eines vorgegebenen Schwellenwertes S liegt (M₁<S). Ist dies der Fall, so wird in einem weiteren Schritt 24 der in Schritt 22 aufgenommene zweite Messwert M₂ daraufhin überprüft, ob dieser oberhalb des vorgegebenen Schwellenwertes S liegt (M₂>S). Ist dies auch der Fall, so wird in einem abschließenden Schritt 25 mittels der Steuereinrichtung 13 des Power-Quality-Feldgerätes 10 ein Ereignis-Signal ES erzeugt.

Wird bei der Überprüfung im Schritt 23 festgestellt, dass der erste Messwert M₁ nicht unterhalb des vorgegebenen Schwellenwertes S liegt, d. h. der erste Messwert M₁ liegt folglich oberhalb des vorgegebenen Schwellenwertes, so wird in einem nunmehr darauf folgenden Schritt 26 überprüft, ob der zweite Messwert M₂ unterhalb des vorgegebenen Schwellenwertes S liegt (M₂<S). Ist dies der Fall, so wird gemäß Schritt 27 mittels der Steuereinrichtung 13 des Power-Quality-Feldgerätes 10 das Ereignis-Signal ES erzeugt.

Wird im Schritt 24 festgestellt, dass der zweite Messwert M₂ nicht oberhalb des Schwellenwertes S liegt (d. h. beide Messwerte M₁ und M₂ liegen unterhalb des Schwellenwertes S), so wird gemäß Schritt 28 kein Ereignis-Signal ES erzeugt. Ebenso wird für den Fall, dass gemäß Schritt 26 festgestellt wird, dass der zweite Messwert M₂ nicht unterhalb des vorgegebenen Schwellenwertes S liegt (d. h. beide Messwerte M₁ und M₂ liegen oberhalb des Schwellenwertes S), gemäß Schritt 29 kein Ereignis-Signal erzeugt.

Nach jedem Durchlauf des Verfahrens erfolgt ein neuer Start bei Schritt 21, wobei der bisher zweite Messwert M₂ nunmehr als erster Messwert M₁ behandelt wird und ein neuer Messwert M₂ erfasst wird.

Um den seltenen Fall abzusichern, dass einer der Messwerte oder sogar beide genau auf dem Schwellenwert S liegen, kann in den Schritten 23, 24 und 26 anstelle der Größer-/Kleiner-Bedingung (z.B. M₁<S) eine Prüfung mit einer Größer-Gleich-/Kleiner-Gleich-Bedingung (z.B. M₁≤S) erfolgen.

Das von der Steuereinrichtung für den Fall einer Schwellenwertverletzung durch die Messwerte M₁ und M₂ erzeugte Ereignis-Signal ES kann beispielsweise dazu verwendet werden, um eine optische Anzeigeeinrichtung 19 des Power-Quality-Feldgerätes 10 zur Abgabe eines optischen Signals zu veranlassen, das dem Betriebspersonal des elektrischen Energieversorgungsnetzes die Schwellenwertverletzung anzeigt. Als optische Anzeigevorrichtung kann im einfachsten Fall eine Lampe oder eine Leuchtdiode verwendet werden, es ist aber auch der Einsatz eines Bildschirms wie eines Displays (z.B. LCD) möglich, mittels dessen zu der Schwellenwertverletzung noch weitere Informationen (z.B. Zeitpunkt der Schwellenwertverletzung, Identifikation des Schwellenwertes) angezeigt werden können.

Das Ereignis-Signal ES kann aber auch dazu verwendet werden, die Steuereinrichtung zur Erzeugung eines Datentelegramms zu veranlassen, das zumindest eine Identifikation des überschrittenen Schwellenwertes enthält. Zusätzlich können in dem Datentelegramm weitere Angaben z.B. bezüglich einer Identifikation des Power-Quality-Feldgerätes 10 (z.B. eine eindeutige Fabrikationsnummer), des Zeitpunktes der Schwellenwertverletzung (einer oder beide der Messzeitpunkte, zu denen die Messwerte M₁ und M₂ erfasst worden sind), die Richtung der Schwellenwertverletzung, d.h. ob der Schwellenwert über- oder unterschritten worden ist, oder die einzelnen Messwerte M₁ und/oder M₂ selbst enthalten. Auch eine Teilauswahl der genannten Angaben kann in dem von der Steuereinrichtung 13 erzeugten Datentelegramm enthalten sein.

Das Datentelegramm kann entweder über die Kommunikationseinrichtung 15 beispielsweise an eine übergeordnete Datenverarbeitungseinrichtung übertragen werden oder in dem Fest-Datenspeicher 14 des Power-Quality-Feldgerätes abgespeichert werden, um von dort zu einem späteren Zeitpunkt ausgelesen zu werden.

Schließlich kann das Ereignis-Signal ES auch dazu verwendet werden, ein Abspeichern des ersten Messwertes M₁ und/oder des zweiten Messwertes M₂ in dem Fest-Datenspeicher des Power-Quality-Feldgerätes zu veranlassen.

Das Ereignis-Signal ES kann zudem auch mehrere der vorgenannten Aktionen in Kombination veranlassen, also beispielsweise das Erzeugen eines Datentelegramms und die Anzeige eines optischen Signals direkt am Power-Quality-Feldgerät.

Zusammengefasst lässt sich damit sagen, dass bei Anwendung des Verfahrens gemäß Figur 2 immer nur dann ein Ereignis-Signal von der Steuereinrichtung 13 des Power-Quality-Feldgerätes 10 erzeugt wird, wenn tatsächlich eine Schwellenwertverletzung stattgefunden hat. Eine solche erkennt die Steuereinrichtung 13 des elektrischen Power-Quality-Feldgerätes 10 daran, dass genau einer der beiden Messwerte unterhalb und einer der beiden Messwerte oberhalb des vorgegebenen Schwellenwertes liegt. Folglich werden keine kontinuierlichen Messwertverläufe in dem elektrischen Power-Quality-Feldgerät abgespeichert. Auch wenn das Ereignis-Signal ES dazu verwendet wird, ein Abspeichern der Messwerte M₁ und M₂ in dem Fest-Datenspeicher 14 des Power-Quality-Feldgerätes zu veranlassen, wird im Vergleich zur kontinuierlichen Messwertabspeicherung erheblicher Speicherplatz eingespart, da nur ereignisabhängig überhaupt eine Abspeicherung von Daten erfolgt. Auf diese Weise werden effektiv weniger Messwerte in dem Fest-Datenspeicher 14 des elektrischen Power-Quality-Feldgerätes 10 abgespeichert. Daher müssen die in dem Fest-Datenspeicher 14 abgespeicherten Messwerte auch nur vergleichsweise selten aus dem Power-Quality-Feldgerät 10 abgerufen werden.

Zusätzlich zu der ersten Power-Quality-Kenngröße, beispielsweise einer Spannung, können an weiteren Messeingängen 12b und 12c der Messeinrichtung 11 des elektrischen Power-Quality-Feldgerätes 10 auch weitere Power-Quality-Kenngrößen, wie beispielsweise eine elektrische Leistung, und eine Frequenz erfasst werden, die anhand des in Figur 2 dargestellten Verfahrens auf Schwellenwertverletzungen jeweils zu den einzelnen weiteren Power-Quality-Kenngrößen gehörender weiterer Schwellenwerte überwacht werden und nur im Falle einer Schwellenwertüberschreitung zum Erzeugen eines Ereignis-Signals ES führen. Hierzu können den einzelnen Messeingängen 12a bis 12c vorgelagerte Messsensoren zum Messen der jeweiligen Messgröße vorhanden sein. Es ist jedoch auch möglich, innerhalb des Power-Quality-Feldgerätes 10 eine Messwertvorverarbeitung vorzunehmen, die beispielsweise anhand eines gemessenen Strom- und Spannungsverlaufes weitere Power-Quality-Kenngrößen, wie Leistung und Frequenz, ermittelt und an die Messwerterfassungseinrichtung 11 des elektrischen Power-Quality-Feldgerätes 10 übergibt.

Bei dem Power-Quality-Feldgerät 10 kann es sich auch um ein kombiniertes Power-Quality-Feldgerät und Schutzgerät handeln. Elektrische Schutzgeräte überwachen Komponenten eines elektrischen Energieversorgungsnetzes auf das Einhalten von vorgegebenen Betriebszuständen, indem beispielsweise Strom- und Spannungsverläufe an der jeweiligen Komponente gemessen werden und anhand von so genannten Schutzalgorithmen geprüft wird, ob sich die Komponente in einem zulässigen Betriebsbereich befindet oder ob ein Fehler, z.B. ein Kurzschluss, vorliegt. Im Falle eines Fehlers wird durch ein elektrisches Schutzgerät die Komponente des elektrischen Energieversorgungsnetzes durch das Öffnen von Leistungsschaltern aus dem Netz abgetrennt, so dass sich der Fehler nicht auf das übrige elektrische Energieversorgungsnetz fortsetzen kann. Durch das Integrieren von Funktionen eines elektrischen Power-Quality-Feldgerätes und eines Schutzgerätes in einem einzigen Feldgerät kann ein meist kostspieliges Vorsehen separater Schutz- und Power-Quality-Feldgeräte vermieden werden.

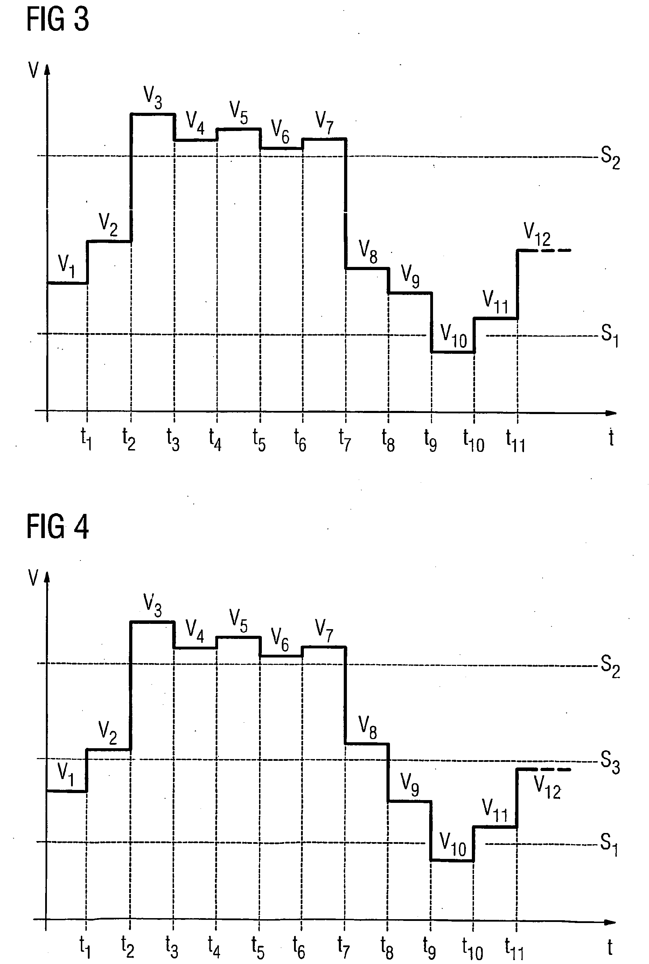

Das in Figur 2 beschriebene Verfahren soll im Folgenden anhand von in Figuren 3 und 4 dargestellten Messwertverläufen weiter veranschaulicht werden.

In Figur 3 ist hierzu beispielhaft der zeitliche Verlauf von Spannungsmesswerten V₁ bis V₁₂ in Form einer Treppenkurve in einem Spannungs-Zeit-Diagramm dargestellt.

Die Darstellung als Treppenkurve wurde deswegen gewählt, weil in Power-Quality-Feldgeräten üblicherweise nicht Momentanwerte einer Power-Quality-Kenngröße, sondern Mittelwerte dieser Power-Quality-Kenngröße ausgewertet werden, da Momentanwerte zufälligen Schwankungen ausgesetzt sein können und daher kurze Spitzen bzw. Extremwerte auftreten können. Die Mittelungsdauer ist üblicherweise einstellbar und reicht beispielsweise von wenigen Millisekunden bis zu einer oder sogar mehreren Minuten oder Stunden. Für die Zwecke der Figuren 3 und 4 soll unter einem Messwert daher das Ergebnis einer Mittelwertbildung über die entsprechende Mittelungsdauer, beispielsweise 10 min, verstanden werden. Alternativ hierzu ist es jedoch genauso möglich, keine Mittelwertbildung durchzuführen und zu aufeinander folgenden Messzeitpunkten Momentan-Messwerte der Power-Quality-Kenngröße aufzunehmen und mit diesen Momentan-Messwerte das in Figur 2 beschriebene Verfahren durchzuführen.

In dem Diagramm in Figur 3 sind ferner ein erster Schwellenwert S₁ und ein zweiter Schwellenwert S₂ durch strichliert dargestellte parallel zur Zeitachse verlaufende Linien angedeutet. Üblicherweise ist nämlich in Normwerken für Power-Quality-Kenngrößen ein Bereich festgeschrieben, innerhalb dessen sich die Power-Quality-Kenngröße befinden muss, um eine ausreichende Qualität der elektrischen Energieversorgung zu gewährleisten. Beim Verlassen dieses Bereichs, also bei Unterschreiten des unteren Schwellenwertes S₁ oder Überschreiten des oberen Schwellenwertes S₂, kann die Qualität der elektrischen Energieversorgung nicht als ausreichend angesehen werden.

Betrachtet man den in Figur 3 dargestellten Messwertverlauf, so erkennt man, dass sowohl der erste als auch der zweite Spannungsmesswert V₁ und V₂ oberhalb des unteren Schwellenwertes S₁ und unterhalb des oberen Schwellenwertes S₂ liegen. Die Steuereinrichtung 13 (vgl. Figur 1) führt bezüglich dieser beiden Spannungsmesswerte das in Figur 2 beschriebene Verfahren durch und erkennt, dass zwischen den Messwerten V₁ und V₂ zum Zeitpunkt t₁ keine Übertritt bezüglich eines der Schwellenwerte S₁ oder S₂ stattfindet. Daher wird bei diesem Verfahrensdurchgang kein Ereignis-Signal ES erzeugt.

Der Spannungsmesswert V₁ kann in diesem Fall vollständig verworfen werden, während der Spannungsmesswert V₂ für einen weiteren Durchlauf des in Figur 2 beschriebenen Verfahrens noch gehalten werden muss. Die Steuereinrichtung 13 des elektrischen Power-Quality-Feldgerätes 10 führt das in Figur 2 dargestellte Verfahren nämlich nunmehr bezüglich der Spannungsmesswerte V₂ und V₃ durch. Die Steuereinrichtung 13 erkennt hierbei, dass der Spannungsmesswert V₂ unterhalb und der Spannungsmesswert V₃ oberhalb des oberen Schwellenwertes S₂ liegt. Mit anderen Worten findet zwischen dem Spannungsmesswert V₂ und dem Spannungsmesswert V₃ ein Überschreiten des oberen Schwellenwertes S₂ statt. Dies hat zur Folge, dass von der Steuereinrichtung 13 des Power-Quality-Feldgerätes 10 ein Ereignis-Signal ES erzeugt wird. Das Vorliegen des Ereignis-Signals ES kann beispielsweise die Steuereinrichtung dazu veranlassen, ein Datentelegramm zu erzeugen, das die Schwellenwertverletzung angibt, und dieses Datentelegramm an eine übergeordnete Datenverarbeitungseinrichtung zu übertragen. Außerdem kann es das Abspeichern des zweiten Spannungsmesswertes V₂ und/oder des dritten Spannungsmesswertes V₃ (ggf. mit dazugehörenden Messzeitpunkten) in dem Fest-Datenspeicher 14 des elektrischen Power-Quality-Feldgerätes 10 abzuspeichern.

Bei weiteren Durchläufen des in Figur 2 beschriebenen Verfahrens bezüglich der Spannungsmesswerte V₃ bis V₇ erkennt die Steuereinrichtung 13 des elektrischen Power-Quality-Feldgerätes keine weiteren Schwellenwertübertritte, da alle Spannungsmesswerte V₃ bis V₇ oberhalb des oberen Schwellenwertes S₂ liegen. Folglich wird in diesen Durchläufen des Verfahrens kein weiteres Ereignis-Signal ES erzeugt.

Erst bei der Betrachtung der Spannungsmesswerte V₇ und V₈ erkennt die Steuereinrichtung 13 einen weiteren Schwellenwertübertritt, und zwar einen Wiedereintritt des Spannungsverlaufes in den erlaubten. In diesem Fall wird also wieder ein Ereignis-Signal erzeugt, was wie oben erläutert unterschiedliche Aktionen auslösen kann.

Entsprechend erkennt die Steuereinrichtung 13 des elektrischen Power-Quality-Feldgerätes 10 zwischen den Spannungsmesswerten V₉ und V₁₀ sowie zwischen den Spannungsmesswerten V₁₀ und V₁₁ eine Verletzung des unteren Schwellenwertes S₁, so dass auch hierbei Ereignis-Signale erzeugt werden.

Bei Betrachtung des in Figur 3 dargestellten Messwertverlaufes erkennt man, dass bei einer kontinuierlichen Messwertabspeicherung zwölf einzelne Spannungsmesswerte (ggf. mit ihren jeweiligen Messzeitpunkten) für eine spätere Auswertung abgespeichert worden wären. Bei Verwendung des in Figur 2 beschriebenen Verfahrens werden lediglich vier Ereignis-Signal erzeugt, die beispielsweise das Generieren von vier Datentelegrammen veranlassen. Unter Beachtung der Tatsache, dass bei realen Messwertverläufen ein Verletzen eines Schwellenwertes deutlich seltener vorkommt als bei dem in Figur 3 gezeigten fiktiven Messwertverlauf, ergibt sich eine deutliche Verringerung der abgespeicherten Datenmenge selbst dann, wenn das Ereignis-Signal ES ein Abspeichern der jeweiligen Spannungsmesswerte in dem Fest-Datenspeicher 14 veranlassen würde.

Das in Figur 4 dargestellte Diagramm zeigt einen prinzipiell ähnlichen Verlauf von Spannungsmesswerten V₁ bis V₁₂ wie Figur 3. In Figur 4 wurde lediglich ein weiterer Schwellenwert S₃ vorgesehen, bezüglich dessen die Lage der einzelnen Messwerte durch die Steuereinrichtung 13 des elektrischen Power-Quality-Feldgerätes 10 abgeprüft wird. Durch eine solche Erhöhung der Anzahl von Schwellenwerten kann entweder die Auswertung der erfassten Power-Quality-Kenngrößen an ein vorgegebenes Normenwerk, in dem mehr als zwei Schwellenwerte vorgeschrieben sind, angepasst werden oder es kann die Auflösung der erzeugten Ereignis-Signale ES erhöht werden, da folglich häufiger ein - jedoch auch spezifischeres - Ereignis-Signal ES erzeugt wird. So werden bei Einführen eines weiteren Schwellenwertes in Figur 4 anstelle von vier Ereignis-Signalen ES (im Fall von Figur 3) nunmehr sechs Ereignis-Signale ES erzeugt. Dies findet immer dann statt, wenn zumindest einer der Schwellenwerte S₁ bis S₃ zwischen zwei aufeinander folgenden Messwerten überschritten wird.

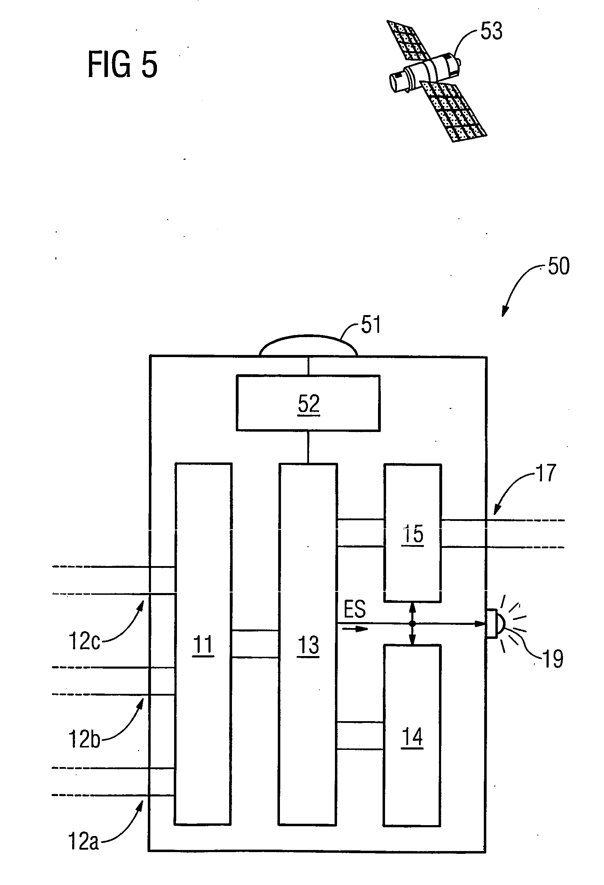

Figur 5 zeigt ein weiteres Ausführungsbeispiel eines elektrischen Power-Quality-Feldgerätes. Das elektrische Power-Quality-Feldgerät 50 gemäß Figur 5 ist ähnlich aufgebaut wie das elektrische Power-Quality-Feldgerät 10 gemäß Figur 1, so dass übereinstimmende Komponenten mit den gleichen Bezugszeichen gekennzeichnet sind. Die Ausführungsform des elektrischen Power-Quality-Feldgerätes 50 gemäß Figur 5 unterscheidet sich von dem Power-Quality-Feldgerät 10 gemäß Figur 1 lediglich durch die Art des Zeitgebers, mit dessen Hilfe die jeweiligen Messzeitpunkte der einzelnen Messwerte festgelegt werden. So weist der in Figur 5 gezeigte Zeitgeber 52 des elektrischen Power-Quality-Feldgerätes 50 eine Empfangseinrichtung 51 auf, mit der ein äußerer Zeittakt empfangen werden kann. Anhand des über die Empfangseinrichtung 51 empfangenen äußeren Zeittaktes stellt der Zeitgeber 52 der Steuereinrichtung 13 des elektrischen Power-Quality-Feldgerätes 50 einen Zeitimpuls zur Verfügung, anhand dessen eine genaue Bestimmung des Messzeitpunktes des jeweiligen Messwertes bezogen auf den äußeren Zeittakt erfolgen kann.

Gemäß Figur 5 kann es sich bei der Empfangseinrichtung 51 des Zeitgebers 52 beispielsweise um einen GPS-Empfänger (Global Positioning System) handeln, der einen von im Orbit installierten GPS-Satelliten 53 ausgesendeten Zeittakt empfängt. Bei dem Zeittakt, der von den GPS-Satelliten 53 ausgesendet wird, handelt es sich um einen hochgenauen Zeittakt mit einer Frequenz von einem Impuls pro Sekunde. Anhand dieses genauen Zeittaktes kann die Steuereinrichtung 13 des elektrischen Power-Quality-Feldgerätes 50 den einzelnen Messwerten einen jeweiligen Messzeitpunkt mit einer Genauigkeit beispielsweise im Mikrosekundenbereich zuordnen. Anstelle eines GPS-Empfängers, der das Signal von GPS-Satelliten empfängt, kann auch jeder weitere Empfänger vorgesehen sein, der dazu geeignet ist ein Signal mit einem außerhalb des Power-Quality-Feldgerätes 50 erzeugten Zeittakt zu empfangen.

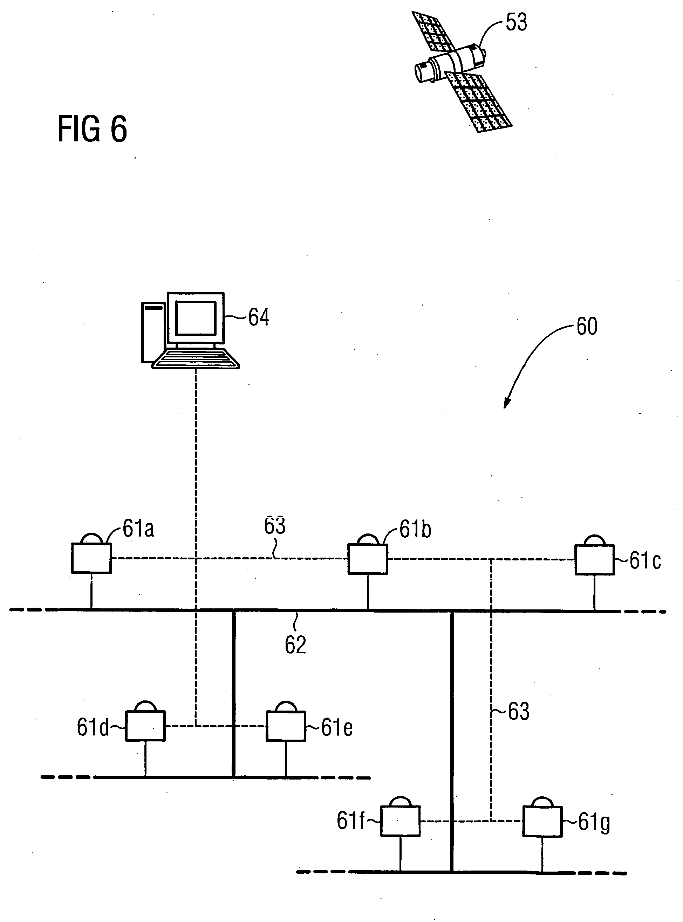

Figur 6 zeigt schließlich ein System bestehend aus mehreren Power-Quality-Feldgeräten 61a bis 61g, die an einem Abschnitt eines nur schematisch dargestellten elektrischen Energieversorgungsnetzes 62 angeordnet sind. Die elektrischen Power-Quality-Feldgeräte 61a bis 61g weisen entsprechend der Darstellung in Figur 5 Empfangseinrichtungen zum Empfangen eines äußeren Zeittaktes, beispielsweise eines GPS-Signals des GPS-Satelliten 53, auf. Auf diese Weise kann erreicht werden, dass alle Zeitgeber in den elektrischen Power-Quality-Feldgeräten 61a bis 61g genau synchron laufen und somit den von den Power-Quality-Feldgeräten 61a bis 61g erfassten Messwerten absolute Messzeitpunkte zugeordnet werden können, die auch in den übrigen Power-Quality-Feldgeräten 61b bis 61g Gültigkeit besitzen und somit untereinander vergleichbar sind. Mit anderen Worten kann auf diese Weise sichergestellt werden, dass ein im Power-Quality-Feldgerät 61b aufgenommener Messwert, dem von der Steuereinrichtung des Power-Quality-Feldgerätes 61b der Messzeitpunkt t₁ zugeordnet worden ist, gleichzeitig mit einem weiteren in dem Power-Quality-Feldgerät 61f erfassten Messwert aufgenommen worden ist, dem von der Steuereinrichtung des Power-Quality-Feldgerätes 61f ebenfalls der Messzeitpunkt t₁ zugeordnet worden ist. Würde kein externer Zeittakt für alle Power-Quality-Feldgeräte 61a bis 61g verwendet werden, so könnte aufgrund der fehlenden Synchronisierung zwischen den Zeitgebern der einzelnen Power-Quality-Feldgeräte 61a bis 61g folglich keine genaue Aussage darüber getroffen werden, ob die Messzeitpunkte t₁ des Feldgerätes 61b und t₁ des Power-Quality-Feldgerätes 61f tatsächlich übereinstimmen. In manchen Fällen kann es jedoch auch ausreichend sein, hochgenaue interne Zeitgeber wie bei dem Beispiel gemäß Figur 1 vorzusehen, wenn keine so hohen Anforderungen an die Synchronisierung der Messwerte der einzelnen Power-Quality-Feldgeräte gestellt werden. Dann kann ein Power-Quality-System auch ohne externen Zeittakt und ohne entsprechende Empfangseinrichtungen aufgebaut sein.

Gemäß Figur 6 sind die einzelnen Power-Quality-Feldgeräte 61a bis 61f über punktiert dargestellte Kommunikationsleitungen untereinander und mit einem Auswerterechner 64 verbunden. Über diese Kommunikationsleitungen können die Inhalte der Datenspeicher der jeweiligen Power-Quality-Feldgeräte 61a bis 61g an den Auswertungsrechner 64 übertragen werden. Beispielsweise kann es sich bei dem Kommunikationsnetzwerk um ein Ethernet-Netzwerk handeln, in dem eine Kommunikation gemäß dem Industriestandard IEC61850 stattfindet. Mit dem Auswerterechner 64 kann somit systemweit für alle betrachteten Power-Quality-Feldgeräte 61a bis 61g eine Aussage darüber getroffen werden, wann und wie häufig eine Verletzung von Schwellenwerten stattgefunden hat.

## Patentansprüche

1. Verfahren zum Überwachen der Elektroenergiequalität in einem elektrischen Energieversorgungsnetz, bei dem folgende Schritte durchgeführt werden:
- Erfassen eines ersten Messwertes einer ersten Power-Quality-Kenngröße mittels einer Messeinrichtung (11) eines an einer Messstelle des elektrischen Energieversorgungsnetzes angeordneten Power-Quality-Feldgerätes (10,50) zu einem ersten Messzeitpunkt und
- Vergleichen des ersten Messwertes mit zumindest einem vorgegebenen Schwellenwert,
**dadurch gekennzeichnet, dass**
- ein zweiter Messwert der ersten Power-Quality-Kenngröße mittels der Messeinrichtung (11) des Power-Quality-Feldgerätes zu einem auf den ersten Messzeitpunkt unmittelbar folgenden zweiten Messzeitpunkt erfasst wird;
- auch der zweite Messwert mit dem zumindest einen vorgegebenen Schwellenwert verglichen wird und
- ein eine Verletzung des zumindest einen Schwellenwertes angebenden Ereignis-Signals genau dann erzeugt wird, wenn einer der beiden Messwerte oberhalb und einer der beiden Messwerte unterhalb des zumindest einen Schwellenwertes liegt.

2. Verfahren nach Anspruch 1, **dadurch gekennzeichnet, dass**
- das Ereignis-Signal zur Ansteuerung einer optischen Signaleinrichtung des Power-Quality-Feldgerätes verwendet wird.

3. Verfahren nach Anspruch 1 oder 2, **dadurch gekennzeichnet, dass**
- das Ereignis-Signal eine Steuereinrichtung des Power-Quality-Feldgerätes zum Erzeugen eines Datentelegramms veranlasst, wobei das Datentelegramm zumindest einen den verletzten Schwellenwert angebenden Datensatz enthält.

4. Verfahren nach Anspruch 3, **dadurch gekennzeichnet, dass**
- das Datentelegramm zusätzlich einen den ersten und/oder den zweiten Messzeitpunkt angebenden Datensatz enthält.

5. Verfahren nach Anspruch 3 oder 4, **dadurch gekennzeichnet, dass**
- das Datentelegramm zusätzlich eine Information darüber enthält, ob der verletzte Schwellenwert durch eine Überschreitung oder eine Unterschreitung verletzt worden ist.

6. Verfahren nach einem der Ansprüche 3 bis 5, **dadurch gekennzeichnet, dass**
- das Datentelegramm zusätzlich den ersten und/oder den zweiten Messwert enthält.

7. Verfahren nach einem der Ansprüche 3 bis 6, **dadurch gekennzeichnet, dass**
- das Datentelegramm in einem Fest-Datenspeicher des Power-Quality-Feldgerätes abgespeichert und/oder an eine dem Power-Quality-Feldgerät übergeordnete Datenverarbeitungseinrichtung übertragen wird.

8. Verfahren nach einem der vorangehenden Ansprüche, **dadurch gekennzeichnet, dass**
- das Ereignis-Signal eine Steuereinrichtung des Power-Quality-Feldgerätes zum Abspeichern des ersten Messwertes und/oder des zweiten Messwertes in einen Fest-Datenspeicher (14) des Power-Quality Feldgerätes veranlasst.

9. Verfahren nach Anspruch 8, **dadurch gekennzeichnet, dass**
- zusätzlich zu den Messwerten auch der erste und/oder der zweite Messzeitpunkt in dem Fest-Datenspeicher (14) abgespeichert werden.

10. Verfahren nach einem der vorangehenden Ansprüche, **dadurch gekennzeichnet, dass**
- das Power-Quality-Feldgerät (50) einen Zeittakt eines geräteinternen Zeitgebers erfasst und anhand dieses Zeittaktes den Messzeitpunkt des jeweiligen Messwertes bestimmt.

11. Verfahren nach einem der Ansprüche 1 bis 9, **dadurch gekennzeichnet, dass**
- das Power-Quality-Feldgerät (50) einen externen Zeittakt erfasst und anhand dieses externen Zeittaktes den Messzeitpunkt des jeweiligen Messwertes bestimmt.

12. Verfahren nach einem der vorangehenden Ansprüche, **dadurch gekennzeichnet, dass**
- neben Messwerten der ersten Power-Quality-Kenngröße auch Messwerte mindestens einer weiteren Power-Quality-Kenngröße erfasst werden und ein weiteres Ereignis-Signal erzeugt wird, wenn zwei zeitlich unmittelbar aufeinander folgenden Messwerte der mindestens einen weiteren Power-Quality-Kenngröße auf unterschiedlichen Seiten zumindest eines weiteren Schwellenwertes liegen.

13. Verfahren nach einem der vorangehenden Ansprüche, **dadurch gekennzeichnet, dass**
- das Ereignis-Signal die Steuereinrichtung auch zur Ausführung von weiteren Power-Quality-Funktionen des Power-Quality-Feldgerätes veranlasst.

14. Power-Quality-Feldgerät (10,50) zum Überwachen der Elektroenergiequalität in einem elektrischen Energieversorgungsnetz mit
- einer Messeinrichtung (11) zum Erfassen von Messwerten einer Power-Quality-Kenngröße an einer Messstelle des elektrischen Energieversorgungsnetzes und einer Steuereinrichtung (13), die derart eingerichtet ist, dass sie die erfassten Messwerte mit zumindest einem vorgegebenen Schwellenwert vergleicht,
**dadurch gekennzeichnet, dass**
die Steuereinrichtung (13) ein Ereignis-Signal erzeugt, wenn von zwei unmittelbar aufeinander folgenden Messwerten einer oberhalb und einer unterhalb des zumindest einen Schwellenwertes liegt.

15. Power-Quality-Feldgerät nach Anspruch 14, **dadurch gekennzeichnet, dass**
- es eine optische Signaleinrichtung aufweist, die bei Vorliegen des Ereignis-Signals aktivierbar ist.

16. Power-Quality-Feldgerät nach Anspruch 14 oder 15, **dadurch gekennzeichnet, dass**
- es eine Kommunikationseinrichtung aufweist, die bei Vorliegen des Ereignis-Signals ein den verletzten Schwellenwert angebendes Datentelegramm an eine dem Power-Quality-Feldgerät übergeordnete Datenverarbeitungseinrichtung sendet.

17. Power-Quality-Feldgerät nach einem der Ansprüche 14 bis 16, **dadurch gekennzeichnet, dass**
- es einen Fest-Datenspeicher aufweist, in dem bei Vorliegen des Ereignis-Signals mittels der Steuereinrichtung zumindest ein den verletzten Schwellenwert angebender Datensatz abgespeichert wird.

18. Power-Quality-Feldgerät (10,50) nach einem der Ansprüche 14 bis 17, **dadurch gekennzeichnet, dass**
- die Steuereinrichtung (13) auch zur Durchführung von Funktionen zum Schutz von Komponenten eines elektrischen Energieversorgungsnetzes eingerichtet ist.

19. Power-Quality-Feldgerät (50) nach einem der Ansprüche 14 bis 18, **dadurch gekennzeichnet, dass**
- es einen geräteinternen Zeitgeber aufweist, der zum Erzeugen eines Zeittaktes eingerichtet ist, und
- die Steuereinrichtung (13) zum Bestimmen des jeweiligen Messzeitpunktes der einzelnen erfassten Messwerte anhand dieses Zeittaktes eingerichtet ist.

20. Power-Quality-Feldgerät (50) nach einem der Ansprüche 14 bis 18, **dadurch gekennzeichnet, dass**
- es eine Empfangseinrichtung (51) aufweist, die zum Empfangen eines externen Zeittaktes eingerichtet ist, und
- die Steuereinrichtung (13) zum Bestimmen des jeweiligen Messzeitpunktes der einzelnen erfassten Messwerte anhand des empfangenen externen Zeittaktes eingerichtet ist.

21. Power-Quality-Feldgerät (50) nach Anspruch 20, **dadurch gekennzeichnet, dass**
- die Empfangseinrichtung (51) ein GPS-Empfänger ist.

22. Power-Quality-System (60) bestehend aus
- mehreren Power-Quality-Feldgeräten (61a bis 61g) gemäß einem der Ansprüche 14 bis 21 und
- zumindest einer zentralen Datenverarbeitungseinrichtung (64), mit dem die Power-Quality-Feldgeräte (61a bis 61g) über ein Datenkommunikationsnetzwerk (63) in Verbindung stehen.

## Claims

1. Method for monitoring the electrical power quality in an electrical power supply system, in which the following steps are carried out:
- detection of a first measured value of a first power quality characteristic variable by means of a measurement device (11) of a power quality field device (10, 50), which is arranged at a measurement point in the electrical power supply system, at a first measurement time; and
- comparison of the first measured value with at least one predetermined threshold value,
**characterized in that**
- a second measured value of the first power quality characteristic variable is detected by means of the measurement device (11) of the power quality field device at a second measurement time, which directly follows the first measurement time;
- the second measured value is also compared with the at least one predetermined threshold value, and
- an event signal, which indicates infringement of the at least one threshold value, is produced exactly when one of the two measured values is above the at least one threshold value and one of the two measured values is below the at least one threshold value.

2. Method according to Claim 1, **characterized in that**
- the event signal is used to control an optical signaling device of the power quality field device.

3. Method according to Claim 1 or 2, **characterized in that**
- the event signal causes a control device for the power quality field device to produce a data message, with the data message including at least one data record which indicates the infringed threshold value.

4. Method according to Claim 3, **characterized in that**
- the data message additionally includes a data record which indicates the first and/or the second measurement time.

5. Method according to Claim 3 or 4, **characterized in that**
- the data message additionally includes information about whether the infringed threshold value has been infringed by overshooting it or undershooting it.

6. Method according to one of Claims 3 to 5, **characterized in that**
- the data message additionally includes the first and/or the second measured value.

7. Method according to one of Claims 3 to 6, **characterized in that**
- the data message is stored in a non-volatile data memory in the power quality field device and/or is transmitted to a data processing facility which is superordinate to the power quality field device.

8. Method according to one of the preceding claims, **characterized in that**
- the event signal causes a control device for the power quality field device to store the first measured value and/or the second measured value in a non-volatile data memory (14) in the power quality field device.

9. Method according to Claim 8, **characterized in that**
- in addition to the measured values, the first and/or the second measurement time are/is also stored in the non-volatile data memory (14).

10. Method according to one of the preceding claims, **characterized in that**
- the power quality field device (50) records a time clock of a device-internal timer and uses this time clock to determine the measurement time of the respective measured value.

11. Method according to one of Claims 1 to 9, **characterized in that**
- the power quality field device (50) records an external time clock and determines the measurement time of the respective measured value on the basis of this external time clock.

12. Method according to one of the preceding claims, **characterized in that**
- in addition to measured values of the first power quality characteristic variable, measured values of at least one further power quality characteristic variable are also detected, and a further event signal is produced when two measured values, with one following the other directly in time, of the at least one further power quality characteristic variable are located on different sides of at least one further threshold value.

13. Method according to one of the preceding claims, **characterized in that**
- the event signal causes the control device to additionally carry out further power quality functions of the power quality field device.

14. Power quality field device (10, 50) for monitoring the electrical power quality in an electrical power supply system having
- a measurement device (11) for detecting measured values, and a control device (13) which is designed such that it compares the detected measured values with at least one predetermined threshold value, **characterized in that** the control device produces an event signal when, of two measured values which follow one another directly, one is above the at least one threshold value and one is below the at least one threshold value.

15. Power quality field device according to Claim 14, **characterized in that**
- the field device has an optical signaling device which can be activated when the event signal is present.

16. Power quality field device according to Claim 14 or 15, **characterized in that**
- the field device has a communication device which, when the event signal is present, sends a data message, which indicates the infringed threshold value, to a data processing facility which is superordinate to the power quality field device.

17. Power quality field device according to one of Claims 14 to 16, **characterized in that**
- the field device has a non-volatile data memory in which, when the event signal is present, at least one data record which indicates the infringed threshold value is stored by means of the control device.

18. Power quality field device (10, 50) according to one of Claims 14 to 17, **characterized in that**
- the control device (13) is also designed to carry out functions for protection of components of an electrical power supply system.

19. Power quality field device (50) according to one of Claims 14 to 18, **characterized in that**
- the field device has a device-internal timer which is designed to produce a time clock, and
- the control device (13) is designed to determine the respective measurement time of the individual detected measured values on the basis of this time clock.

20. Power quality field device (50) according to one of Claims 14 to 18, **characterized in that**
- the field device has a receiving device (51) which is designed to receive an external time clock, and
- the control device (13) is designed to determine the respective measurement time of the individual detected measured values on the basis of the received external time clock.

21. Power quality field device (50) according to Claim 20, **characterized in that**
- the receiving device (51) is a GPS receiver.

22. Power quality system (60) comprising
- a plurality of power quality field devices (61a to 61g) according to one of Claims 14 to 21, and
- at least one central data processing facility (64), to which the power quality field devices (61a to 61g) are connected via a data communication network (63).

## Revendications

1. Procédé de contrôle de la qualité de l'énergie électrique dans un réseau d'alimentation électrique, dans lequel on effectue les stades suivants :
- on relève une première valeur de mesure d'une première grandeur caractéristique de Power-Quality au moyen d'un dispositif ( 11 ) de mesure d'un appareil ( 10, 50 ) sur site Power-Quality disposé en un point de mesure du réseau d'alimentation en énergie électrique à un premier instant de mesure, et
- on compare la première valeur de mesure à au moins une valeur de seuil prescrite,
**caractérisé en ce que**
- on relève une deuxième valeur de mesure de la première grandeur caractéristique de Power-Quality au moyen du dispositif ( 11 ) de mesure de l'appareil sur site Power-Quality à un deuxième instant de mesure suivant immédiatement le premier instant de mesure ;
- on compare aussi la deuxième valeur de mesure à la au moins une valeur de seuil prescrite et
- on produit un signal d'événement indiquant une violation de la au moins une valeur de seuil, si l'une des deux valeurs de mesure se trouve au-dessus et l'une des deux valeurs de mesure en dessous de la au moins une valeur de seuil.

2. Procédé suivant la revendication 1, **caractérisé en ce que**
- on utilise le signal d'événement pour commander un dispositif optique de signalisation de l'appareil sur site Power-Quality.

3. Procédé suivant la revendication 1 ou 2, **caractérisé en ce que**
- le signal d'événement fait qu'un dispositif de commande de l'appareil sur site Power-Quality produit un télégramme de données, le télégramme de données contenant au moins un jeu de données indiquant la valeur de seuil violée.

4. Procédé suivant la revendication 3, **caractérisé en ce que**
- le télégramme de données contient supplémentairement un jeu de données indiquant le premier et/ou le deuxième instant de mesure.

5. Procédé suivant la revendication 3 ou 4, **caractérisé en ce que**
- le télégramme de données contient supplémentairement une information sur le point de savoir si la valeur de seuil violée a été violée par un dépassement par le haut ou par un dépassement par le bas.

6. Procédé suivant l'une des revendications 3 à 5, **caractérisé en ce que**
- le télégramme de données contient supplémentairement la première et/ou la deuxième valeur de mesure.

7. Procédé suivant l'une des revendications 3 à 6, **caractérisé en ce que**
- le télégramme de données est mémorisé dans une mémoire de données morte de l'appareil sur site Power-Quality et/ou est transmis à un dispositif informatique préposé à l'appareil sur site Power-Quality.

8. Procédé suivant l'une des revendications précédentes, **caractérisé en ce que**
- le signal d'événement fait qu'un dispositif de commande de l'appareil sur site Power-Quality provoque la mémorisation de la première valeur de mesure et/ou de la deuxième valeur de mesure dans une mémoire ( 14 ) de données morte de l'appareil sur site Power-Quality.

9. Procédé suivant la revendication 8, **caractérisé en ce que**
- on mémorise supplémentairement aux valeurs de mesure également le premier et/ou le deuxième instant de mesure dans la mémoire ( 14 ) de données morte.

10. Procédé suivant l'une des revendications précédentes, **caractérisé en ce que**
- l'appareil ( 50 ) sur site Power-Quality relève une cadence d'un générateur de cadence interne à l'appareil et détermine l'instant de mesure de la valeur de mesure respective au moyen de cette cadence.

11. Procédé suivant l'une des revendications 1 à 9, **caractérisé en ce que**
- l'appareil ( 50 ) sur site Power-Quality relève une cadence extérieure et détermine l'instant de mesure de la valeur de mesure respective au moyen de cette cadence extérieure.

12. Procédé suivant l'une des revendications précédentes, **caractérisé en ce que**
- outre des valeurs de mesures de la première grandeur caractéristique de Power-Quality, on relève aussi des valeurs de mesure d'au moins une autre grandeur caractéristique de Power-Quality et on produit un autre signal d'événement lorsque deux valeurs de mesure, se succédant immédiatement dans le temps, de la au moins une autre grandeur caractéristique de Power-Quality, se trouvent sur des côtés différents d'au moins une autre valeur de seuil.

13. Procédé suivant l'une des revendications précédentes, **caractérisé en ce que**
- le signal d'événement du dispositif de commande provoque aussi la réalisation d'autres fonctions Power-Quality de l'appareil sur site Power-Quality.

14. Appareil ( 10, 50 ) sur site Power-Quality de contrôle de la qualité de l'énergie électrique d'un réseau d'alimentation en énergie électrique, comprenant :
- un dispositif ( 11 ) de mesure, pour relever des valeurs de mesure d'une grandeur caractéristique de Power-Quality en un emplacement de mesure du réseau d'alimentation en énergie électrique et un dispositif ( 13 ) de commande, qui est tel qu'il compare les valeurs de mesure relevées à au moins une valeur de seuil prescrite,
**caractérisé en ce que**
le dispositif ( 13 ) de commande produit un signal d'événement lorsque deux valeurs de mesure se succédant directement sont l'une au-dessus et l'autre en dessous de la au moins une valeur de seuil.

15. Appareil sur site Power-Quality suivant la revendication 14, **caractérisé en ce que**
- il a un dispositif optique de signalisation, qui peut être activé en présence du signal d'événement.

16. Appareil sur site Power-Quality suivant la revendication 14 ou 15, **caractérisé en ce que**
- il a un dispositif de communication, qui, en présence du signal d'événement, envoie un télégramme de données indiquant que la valeur de seuil est violée à un dispositif informatique préposé à l'appareil sur site Power-Quality.

17. Appareil sur site Power-Quality suivant l'une des revendications 14 à 16, **caractérisé en ce que**
- il a une mémoire de données morte, dans laquelle, en présence du signal d'événement, au moins un jeu de données indiquant la valeur de seuil violée est mémorisé au moyen du dispositif de commande.

18. Appareil ( 10, 50 ) sur site Power-Quality suivant l'une des revendications 14 à 17, **caractérisé en ce que**
- le dispositif ( 13 ) de commande est conçu pour effectuer aussi des fonctions de protection de composants d'un réseau d'alimentation en énergie électrique.

19. Appareil ( 50 ) sur site Power-Quality suivant l'une des revendications 14 à 18, **caractérisé en ce que**
- il a une horloge interne à l'appareil, qui est conçue pour produire une cadence, et
- le dispositif ( 13 ) de commande est conçu pour déterminer, au moyen de cette cadence, l'instant de mesure respectif des diverses valeurs de mesure relevées.

20. Appareil ( 50 ) sur site Power-Quality suivant l'une des revendications 14 à 18, **caractérisé en ce que**
- il a un dispositif ( 51 ) de réception, qui est conçu pour recevoir une cadence extérieure, et
- le dispositif ( 13 ) de commande est conçu pour déterminer, au moyen de la cadence extérieure reçue, l'instant de mesure respectif des diverses valeurs de mesure relevées.

21. Appareil ( 50 ) sur site Power-Quality suivant la revendication 20, **caractérisé en ce que**
- le dispositif ( 51 ) de réception est un récepteur GPS.

22. Système ( 60 ) Power-Quality constitué
- de plusieurs appareils ( 61a à 61g ) sur site Power-Quality suivant l'une des revendications 14 à 21 et
- d'au moins un dispositif ( 64 ) informatique central, avec lequel les appareils ( 61 a à 61g ) sur site Power-Quality sont en liaison par un réseau ( 63 ) de communication de données.
